# EUROPEAN PATENT APPLICATION

(11) **EP 1 516 891 A1**
(43) Date of publication of application: **23.03.2005**
(21) Application number: 04104518.8
(22) Date of filing: 17.09.2004
(51) Int. Cl.: C08L 63/00, C08L 79/08, C08G 18/02, C08G 59/40, C09J 163/00, C09J 179/08

(54) **A binder composition for lamination and an adhesive film using the same**

(30) Priority: 22.09.2003 JP 2003329577
(71) Applicant: NISSHINBO INDUSTRIES, INC., Tokyo 103 (JP)
(72) Inventor: Takahashi, Ikuo, Midori-ku Chiba, 267-0056 (JP); Tomita, Hideshi, Midori-ku Chiba, 267-0056 (JP)
(74) Representative: Gaglione, Renaud

(57) **Abstract**

A binder composition suitable for electronic parts applications adapted to lamination treatments, which has particularly superior storage stability and adhesive strength as well as high elastic modulus even at high temperature, and an adhesive film using the same. More concretely, a binder composition for lamination to be used for such as adhesion of copper foil onto glass fiber reinforced epoxy resin substrate, characterized by containing a carbodiimide resin (a) and a high molecular weight epoxy resin (b) having average molecular weight of not lower than 500, and ratio of both components being 30 to 200 parts by weight of (b) based on 100 parts by weight of (a), as well as an adhesive film using the same, and the like.

## Description

### BACKGROUND OF THE INVENTION

### FIELD OF THE INVENTION

The present invention relates to a binder composition for laminating electronic parts and an adhesive film using the same, and more specifically the present invention relates to a binder composition having superior storage stability and adhesiveness that is suitable for laminating electronic parts, for example, adhesion of copper foil to glass fiber reinforced epoxy resin substrate and contains a carbodiimide resin and a high molecular weight epoxy resin having average molecular weight of not lower than 500, as well as an adhesive film using the same.

### DESCRIPTION OF THE PRIOR ART

In electronic parts applications, copper foil is adhered to substrate, for example, glass fiber reinforced epoxy resin substrate to which a binder is applied in advance, to produce laminated substrate materials.

Binder compositions corresponding to such laminate applications have been proposed, such as a urethane resin-based two-component binder comprising a polyol component (1) and a polyisocyanate component (2) wherein ratio of a hydroxyl group of the polyol component (1) and an isocyanate group of the polyisocyanate component (2) is specified within a particular range (for example, see JP-A-2003-96428), and an epoxy resin-based binder comprising an epoxy resin having not less than two epoxy groups in a molecule, a curing agent as well as its promoter, a rubber resin, a rubber crosslinking agent comprising a phenol resin, an inorganic filler, a solvent and the like, to be used for a circuit board for an IC card laminated with conductive foil and firmly adhered with an IC on the back side (for example, see JP-A-7-276869).

Further, in electronic parts applications, an adhesive resin and a binder having higher heat resistance with requirement of higher reliability due to higher soldering temperature reflected by lead-free soldering and finer wiring.

However, a binder comprising a urethane-based resin material poses a problem not to be adaptable for a field requiring higher strength at high temperature, due to its lower thermal decomposition temperature and its lower heat resistance (elastic modulus at high temperature), although having good adhesiveness.

A binder comprising an epoxy-based resin material also poses a problem to lose shape stability or easily deformed when pressurized at about 170 °C due to low elastic modulus at temperature over low glass transition temperature of about 130 °C.

In addition, binders comprising a urethane-based resin material or an epoxy-based material are not adaptable for electronic parts applications requiring higher heat resistance, because a cured material of a single binder component is generally fragile and thus a rubber component needs to be added to respond to bending of a laminated body to be adhered, resulting in low heat resistance thereof.

On the other hand, a carbodiimide resin-based binder composition with high heat resistance, mainly composed of a polycarbodiimide resin and an epoxy resin, is proposed (for example, see JP-A-5-239427, JP-A-5-320611 and JP-A-2000-104022).

However, a conventional binder composition mainly composed of a polycarbodiimide resin and an epoxy resin has a problem of poor storage stability, showing increase in hardness and extremely decreased adhesion when left at 50 °C for one day. In this connection, such storage stability that adhesiveness can be maintained even when left at 50 °C for five days has been required.

Performances required for an adhesive lamination film to be used for binding electronic parts include: (i) to be detached (or attached) through pressure heating treatment for a short period by a heated roll; (ii) not to be detached from a substrate film such as a polyester film (for example, PET) before lamination process and to be easily detached therefrom after lamination; (iii) to be free from oozing in lamination treatment; (iv) to prevent a partial delamination in a punching step for laminated substrate, in other words, to have high adhesiveness; (v) to have elastic modulus at 170 °C of an order of not lower than 10⁸ Pa after curing, to suppress deformation in injection molding; (vi) to have a peel strength for copper foil of not lower than 150 g/cm and the like. A binder composition for lamination is required to satisfy these performances as well as the above-described heat resistance and storage stability.

### SUMMARY OF THE INVENTION

Therefore, an object of the present invention is to provide a binder composition suitable for electronic parts applications adapted to lamination treatment that has particularly superior storage stability and adhesive strength as well as high elastic modulus even at high temperature, and an adhesive film using the same.

The inventors of the present invention have found, after having extensively studied to overcome the above-described problems of the prior art, that the binder composition for laminating electronic parts, that has superior storage stability and adhesive strength as well as high elastic modulus even at high temperature, can be obtained by containing a carbodiimide resin and a high molecular weight epoxy resin having average molecular weight of not lower than 500 as essential components thereof at specific ratio and completed the present invention based on the above knowledge.

The first aspect of the invention provides a binder composition for lamination, characterized by containing a carbodiimide resin (a) and a high molecular weight epoxy resin (b) having average molecular weight of not lower than 500, and ratio of both components being 30 to 200 parts by weight of (b) based on 100 parts by weight of (a).

The second aspect of the invention provides the binder composition for lamination according to the first aspect, characterized in that the carbodiimide resin (a) has degree of polymerization (n) of not lower than 50.

The third aspect of the invention provides the binder composition for lamination according to the second aspect, characterized in that the carbodiimide resin (a) has number-average molecular weight of 3,000 to 100,000 converted to polystyrene by gel permeation chromatography.

The fourth aspect of the invention provides the binder composition for lamination according to any one of the first to third aspects, characterized in that the carbodiimide resin (a) is obtained from at least one kind of aromatic polyisocyanates.

The fifth aspect of the invention provides the binder composition for lamination according to the first aspect, characterized by further containing at least one kind of plasticizers or inorganic fillers.

The sixth aspect of the invention provides the binder composition for lamination according to any one of the first to fifth aspects, characterized in that the high molecular weight epoxy resin (b) is in solid state at ordinary temperature and has softening point of not lower than 60 °C.

The seventh aspect of the invention provides the binder composition for lamination according to any one of the first to sixth aspects, characterized by having elastic modulus at 170 °C of an order of not lower than 10⁸ Pa after curing.

The eighth aspect of the invention provides the binder composition for lamination according to any one of the first to seventh aspects, characterized by being used for adhesion of copper foil onto glass fiber reinforced epoxy resin substrate.

The ninth aspect of the invention provides an adhesive film is provided, characterized by comprising a laminated binder layer of the binder composition for lamination according to any one of the first to eighth aspects, on a surface of a substrate film made of polyethylene terephthalate.

A binder composition for laminating electronic parts of the present invention has particular effect of superior storage stability, in addition to less deformation tendency even at high temperature, no delamination in punching treatment after lamination because of high adhesiveness thereof, high adhesiveness in humid environment or the like, by containing, at specific ratio, a carbodiimide resin (a) and a high molecular weight epoxy resin (b) having average molecular weight of not lower than 500.

Therefore, the composition can be suitably used for laminating electronic parts, for example, adhesion of copper foil to glass fiber reinforced epoxy resin substrate.

### BEST MODE FOR CARRYING OUT THE INVENTION

A binder composition for lamination or the like of the present invention will be described below in detail for each item.

A binder composition for lamination of electronic parts, such as for adhesion of copper foil on glass fiber reinforced epoxy resin substrate is characterized by containing, at specific ratio, a carbodiimide resin (a) and a high molecular weight epoxy resin (b) having average molecular weight of not lower than 500.

### 1. A carbodiimide resin (a)

A carbodiimide resin (a) to be used in the present invention may be manufactured in various methods. Polycarbodiimide having terminal isocyanate groups may be used, which is manufactured fundamentally by a conventional method for manufacturing of polycarbodiimide (U.S.Pat.No.2,941,956, JP-B-47-33279, J. Org. Chem., 28, 2069-2075 (1963), Chemical Review 1981, Vol.81, No.4 p619-621), and specifically manufactured by a condensation reaction accompanied by removal of carbon dioxide from an organic polyisocyanate.

An organic polyisocyanate such as an aromatic polyisocyanate, an aliphatic polyisocyanate, an alicyclic polyisocyanate and a mixture thereof can be used as a raw material for synthesizing a polycarbodiimide compound in the above-described method.

Specific examples of the organic polyisocyanate include 1,5-naphthalene diisocyanate, 4,4'-diphenylmethane diisocyanate, 4,4'-diphenyldimethylmethane diisocyanate, 1,3-phenylene diisocyanate, 1,4-phenylene diisocyanate, 2,4-tolylene diisocyanate, 2,6-tolylene diisocyanate, a mixture of 2,4-tolylene diisocyanate and 2,6-tolylene diisocyanate, hexamethylene diisocyanate, cyclohexane-1,4-diisocyanate, xylylene diisocyanate, isophorone diisocyanate, dicyclohexylmethane-4,4'-diisocyanate, methylcyclohexane diisocyanate, tetramethylxylylene diisocyanate, 2,6-diisopropylphenyl isocyanate and 1,3,5-triisopropylbenzene-2,4-diisocyanate.

A carbodiimide resin (a) to be used in the present invention is preferably an aromatic resin having high heat resistance and self-crosslinking reactivity, specifically derived from at least one kind of aromatic polyisocyanates. An aromatic polyisocyanate means herein an isocyanate containing at least two isocyanate groups directly bonded to an aromatic ring in one molecule thereof.

The above organic diisocyanate can also be obtained by suitably controlling degree of polymerization using a compound to react with a terminal isocyanate of a carbodiimide compound such as a monoisocyanate.

Monoisocyanates for capping a terminal of polycarbodiimide to control degree of polymerization include, for example, phenyl isocyanate, tolyl isocyanate, dimethylphenyl isocyanate, cyclohexyl isocyanate, butyl isocyanate and naphthyl isocyanate.

In addition, compounds that can react with a terminal isocyanate as a capping agent to be used in the present invention, include aliphatic compounds, aromatic compounds and alicyclic compounds, such as methanol, ethanol, phenol, cyclohexanol, N-methylethanolamine, polyethylene glycol monomethyl ether and polypropylene glycol monomethyl ether which have an -OH group; diethylamine and dicyclohexylamine which have an =NH group; butylamine and cyclohexylamine which have an -NH₂ group; propionic acid, benzoic acid and cyclohexane carboxylic acid which have a -COOH group; ethylmercaptan, allylmercaptan and thiophenol which have an -SH group; and a compound having an epoxy group.

A decarboxylation-condensation reaction of the above organic diisocyanate proceeds in the presence of a carbodiimidation catalyst, for which phospholene oxides such as 1-phenyl-2-phospholene-1-oxide, 3-methyl-1-phenyl-2-phospholene-1-oxide, 1-ethyl-2-phospholene-1-oxide, 3-methyl-2-phospholene-1-oxide and 3-phospholene isomers thereof can be used. Among these, 3-methyl-1-phenyl-2-phospholene-1-oxide is suitable from the standpoint of reactivity.

A carbodiimide resin (a) to be used for a binder composition for lamination of the present invention has low compatibility with a high molecular weight epoxy resin (b) having average molecular weight of not lower than 500, leading to good stability of the composition. Degree of polymerization (n) of a carbodiimide resin is preferably not lower than 5 from the standpoints of storage stability and film formation, because a carbodiimide resin having lower molecular weight tends to have higher solubility and reactivity with an epoxy resin.

Number-average molecular weight (Mn) of a carbodiimide resin converted to polystyrene by gel permeation chromatography (GPC) may be 3,000 to 100,000, preferably 5,000 to 100,000. Molecular weight of a carbodiimide resin below 3,000 results in a less flexible film, while molecular weight over 100,000 not only makes synthesis difficult but also extremely lowers pot life (usable period) of varnish of a carbodiimide resin obtained and thus not practical.

### 2. A high molecular weight epoxy resin (b)

A high molecular weight epoxy resin (b) to be used in the present invention has average molecular weight (MN) of not lower than 500. It is in solid state at ordinary temperature and preferably has softening point of not lower than 60 °C.

Use of a high molecular weight epoxy resin (b) in the present invention can suppress fluidity of a carbodiimide resin (a), resulting in good storage stability.

An epoxy resin includes, such as a glycidyl ether type epoxy resin represented by a bisphenol A (Bis.A) type epoxy resin, a bisphenol F type epoxy resin, a phenol-novolac type epoxy resin and a cresol-novolac type epoxy resin, and one kind of or a mixture of an epoxy resin having at least two epoxy groups in one molecule thereof such as an alicyclic epoxy resin, a glycidyl ester type epoxy resin, a heterocyclic epoxy resin and a liquid rubber-modified epoxy resin and the like. A phenol-novolac type epoxy resin, a cresol- novolac type epoxy resin, Bis.A type epoxy resin and a bisphenol F type epoxy resin are preferable, however, a high molecular weight epoxy resin to be used in the present invention is not limited to these but may be a generally known epoxy resin, provided that it has the above-described average molecular weight of not lower than 500.

### 3. A binder composition for lamination

Mixing (containing) ratio of the above-described carbodiimide resin (a) and high molecular weight epoxy resin (b), in a binder composition for lamination of the present invention, may be 30 to 200 parts by weight, preferably 50 to 150 parts by weight, more preferably 50 to 100 parts by weight of the high molecular weight epoxy resin (b) based on 100 parts by weight of the carbodiimide resin (a). Said mixing ratio of less than 30 parts by weight of the high molecular weight epoxy resin (b) can not furnish stability improvement effect to the carbodiimide resin, while, said mixing ratio over 200 parts by weight provides low crosslinking density and reduced hardness at high temperature and thus not preferable.

In addition to the above carbodiimide resin (a) and high molecular weight epoxy resin (b), a binder composition for lamination of the present invention may further be added with a plasticizer to improve flexibility, or an inorganic filler such as inorganic powder to enhance elastic modulus or adhesiveness, in an amount not to impair performance of a binder composition for lamination of the present invention.

The plasticizers include, for example, dioctyl phthalate (DOP) and a pyromellitic acid-trimellitic acid type plasticizer. The inorganic fillers include, for example, silica, quartz powder, alumina, calcium carbonate, magnesium oxide, diamond powder, mica, fluorocarbon resin and zircon powder.

A binder composition of the present invention is used as an adhesive film for lamination. Both of the above-described components, a carbodiimide resin (a) and a high molecular weight epoxy resin (b), as well as a plasticizer and an inorganic filler, if desired, are mixed to obtain an adhesive film for lamination. The above components may be mixed at room temperature or by heating, or after dissolving the high molecular weight epoxy resin in an appropriate solvent, however, a mixing method is not specifically limited.

A normal method for obtaining a binder composition comprises, for example, dissolving of a high molecular weight epoxy resin in a solution of a carbodiimide resin, followed by casting thus obtained solution by a known method such as using a coater on a surface of a substrate film made of polyethylene terephthalate (PET) and removing a solvent by heating or the like. By such a method, an adhesive film for lamination can be obtained by lamination of a binder layer made of a binder composition for lamination on a surface of a substrate film made of polyethylene terephthalate.

A polyethylene terephthalate (PET) film of about 25 µ m thickness is preferable as a substrate film. This is because slitting is difficult in the case of a thicker or softer adhesive film.

A method for using an adhesive film for lamination relevant to the present invention is, for example, to laminate the adhesive film onto glass fiber reinforced epoxy resin substrate and then to adhere to copper foil by lamination, to obtain a substrate material. A binder layer of an adhesive film is generally soft at room temperature, getting softer and stickier when heated mildly, and cures to exert adhesion strength when heated further.

Copper foil can be adhered firmly to glass fiber reinforced epoxy resin substrate through pressure heating treatment for a short period by a heated roll, using an adhesive film for lamination having superior adhesive strength relevant to the present invention. Partial peeling-off (delamination) from substrate in punching processing can be prevented because of high adhesiveness.

Further, an adhesive film for lamination relevant to the present invention has such level of superior storage stability as to maintain adhesiveness even when left at 50 °C for five days, because the components of the binder layers are not reactive at low temperature, while, a conventional adhesive film loses adhesiveness when left at 50 °C for one day.

A binder layer of an adhesive film for lamination relevant to the present invention is free from deformation in injection molding process usually at 170 to 175 °C because of its elastic modulus at 170 °C of an order of 10⁸ Pa after curing. High glass transition point of not lower than 200 °C of a binder layer is another reason for little deformation even at high temperature.

### EXAMPLES AND COMPARATIVE EXAMPLES

The present invention will be described in more detail in Examples below. Synthesis Examples of carbodiimide resins to be used in Examples and Comparative Examples will be presented in advance.

### [Synthesis Example 1 of a carbodiimide resin]

MDI (4,4'-diphenylmethane diisocyanate) of 100.0 g, tetrahydrofuran (THF) of 847.7 g and 3-methyl-1-phenyl-2-phospholene oxide of 0.2 g were loaded in a 2 liter four-necked flask dipped in an oil bath at 80 °C, followed by reaction for 16 hours under refluxing to obtain a solution of a carbodiimide resin having number-average molecular weight (Mn) of 17,000.

### [Synthesis Example 2 of a carbodiimide resin]

MDI of 120 g, phenyl isocyanate of 1.16 g, tetrahydrofuran (THF) of 890 g and 3-methyl-1-phenyl-2-phospholene oxide of 0.26 g were loaded in a 2 liter four-necked flask dipped in an oil bath at 80 °C, followed by reaction for 12 hours under refluxing to obtain a solution of a carbodiimide resin having number-average molecular weight (Mn) of 11,000.

### [Example 1]

The aromatic carbodiimide resin of 100 parts by weight, provided as a THF solution in Synthesis Example 1, was added with 80 parts by weight of a phenol-novolac type epoxy resin (MN=780, epoxy equivalent: 195, softening point: 75 °C) and cast on mold-releasing treated PET (polyethylene terephthalate) using a coater to prepare a binder layer of 20 µm thickness.

### [Example 2]

The aromatic carbodiimide resin of 100 parts by weight, provided as a THF solution in Synthesis Example 2, was added with 30 parts by weight a Bis.A type high molecular weight epoxy resin (MN=1,260, epoxy equivalent: 630, softening point: 84 °C) and 50 parts by weight of a cresol- novolac type epoxy resin (MN=810, epoxy equivalent: 210, softening point: 76 °C) and cast on mold-releasing treated PET using a coater to prepare a binder layer of 30 µm thickness.

### [Example 3]

The aromatic carbodiimide resin of 100 parts by weight, provided as a THF solution in Synthesis Example 2, was added with 60 parts by weight of a Bis.A type high molecular weight epoxy resin (MN=1,860, epoxy equivalent: 930, softening point: 99 °C) and 40 parts by weight of a bisphenol A type epoxy resin (MN=388, epoxy equivalent: 194, liquid) and cast on a mold-releasing treated PET film using a coater to prepare a binder layer of 30 µm thickness.

### [Comparative Example 1]

Polyethylene glycol of 150 parts by weight and neopentyl glycol of 250 parts by weight added with isophthalic acid of 500 parts by weight were heated and reacted under a nitrogen gas flow to obtain a polyester polyol resin. Thus obtained polyester polyol resin of 100 parts by weight was added with 40 parts by weight of an aliphatic isocyanate, HMDI, and cast on a mold-releasing treated PET film to prepare a binder layer of 30 µm thickness.

### [Comparative Example 2]

To 100 parts by weight of a Bis.A type epoxy resin, dissolved in MEK, was added 5 parts by weight of imidazole, followed by casting on a mold-releasing treated PET film using a coater to prepare a binder layer of 30µm thickness.

### [Comparative Example 3]

An aromatic carbodiimide resin alone, dissolved in THF, was cast on a mold-releasing treated PET film to prepare a binder layer of 20µm thickness.

### [Comparative Example 4]

To 100 parts by weight of an aromatic carbodiimide resin, dissolved in THF, was added with 75 parts by weight of a Bis.A type epoxy resin, followed by casting on a mold-releasing treated PET film using a coater to prepare a binder layer of 30µm thickness.

### [Comparative Example 5]

To 100 parts by weight of a Bis.A type high molecular weight epoxy resin, dissolved in MEK, was added 5 parts by weight of imidazole, followed by casting on a mold-released PET film to prepare a binder layer of 30µm thickness.

Each binder film thus prepared, which was still attached on each substrate PET film, was adhered on glass fiber reinforced epoxy resin substrate by a heated roll set at 110 °C to obtain test pieces.

These test pieces were evaluated based on the evaluation criteria below. Results of comparative evaluation are shown in Table 1.

### [Delamination]

A hole of 6 mm diameter was punched in glass fiber reinforced epoxy resin substrate adhered with a PET film, from the PET film side, and interlayer peeling-off state between the glass fiber reinforced epoxy resin substrate and the film was evaluated by naked eye observation of peripheral of the hole.
O: No peeling-off was observed
x: A partial peeling-off was observed

### [Storage Stability]

After each test piece was left at 50 °C for 7 days, the PET film was peeled from the test piece. Copper foil was adhered to the site of the test piece where the PET film had been attached to, using a heated roll set at 140 °C. After the test piece was cooled to room temperature, adhered state and adhesion strength were checked.
O: No insufficient adhesion was observed between the copper foil and the binder layer. Peel strength was not lower than 150 g/cm in a 180° peeling test in accordance with JIS K6854.
Δ: No insufficient adhesion was observed, but peel strength was under 150 g/cm.
× : Insufficient adhesion was observed where the copper foil was not adhered to the binder layer.

### [Deformation at 170 °C]

Adhered copper foil was slit by etching in 50 µm width at an interval of 50 µm. A resin heated to 170 °C was injection-molded on the copper foil, and deformation and peeling-off of the copper foil were observed.

**Table 1**

| | Occurrence of delamination | Storage stability | Deformation at 170 °C |
|---|---|---|---|
| Example 1 | ○ | ○ | Nil |
| Example 2 | O | O | Nil |
| Example 3 | O | ○ | Nil |
| Comparative Example 1 | ○ | ○ | Yes (foaming) |
| Comparative Example 2 | × | Δ | Yes |
| Comparative Example 3 | ○ | × | Nil |
| Comparative Example 4 | × | × | Nil |
| Comparative Example 5 | ○ | ○ | Yes |

As apparent from the results of Examples and Comparative Examples shown in Table 1, Examples 1 to 3 using a binder composition of the present invention containing a carbodiimide resin (a) and a high molecular weight epoxy resin (b) are superior in all of delamination resistance, storage stability and deformation resistance at 170 °C.

In contrast, Comparative Example 1, which is a binder made of a common urethane resin shows deformation and foaming at 170 °C, and Comparative Example 2, which is a binder made of a common epoxy resin is inferior in all of delamination resistance, storage stability and deformation resistance at 170 °C. Comparative Example 3, which is a binder layer made of an aromatic carbodiimide resin alone is inferior in storage stability, while Comparative Example 4, which uses a binder composition containing a carbodiimide resin (a) and a low molecular weight epoxy resin is inferior in delamination resistance and storage stability. Comparative Example 5, which is a binder made of a high molecular weight epoxy resin is inferior in deformation resistance at 170 °C.

It has become apparent from these evaluation results that a binder composition of the present invention containing a carbodiimide resin (a) and a high molecular weight epoxy resin (b) at specified ratio is especially superior in storage stability in addition to little deformation even at high temperature, superior adhesiveness so that no delamination is seen in punching after lamination and superior adhesiveness in humid environment.

## Claims

1. A binder composition for lamination, **characterized by** containing a carbodiimide resin (a) and a high molecular weight epoxy resin (b) having average molecular weight of not lower than 500, and ratio of both components being 30 to 200 parts by weight of (b) based on 100 parts by weight of (a).

2. The binder composition for lamination according to claim 1, **characterized in that** the carbodiimide resin (a) has degree of polymerization (n) of not lower than 50.

3. The binder composition for lamination according to claim 2, **characterized in that** the carbodiimide resin (a) has number-average molecular weight of 3,000 to 100,000 converted to polystyrene by gel permeation chromatography.

4. The binder composition for lamination according to any one of claims 1 to 3, **characterized in that** the carbodiimide resin (a) is obtained from at least one kind of aromatic polyisocyanates.

5. The binder composition for lamination according to claim 1, **characterized by** further containing at least one kind of plasticizers or inorganic fillers.

6. The binder composition for lamination according to any one of claims 1 to 5, **characterized in that** the high molecular weight epoxy resin (b) is in solid state at ordinary temperature and has softening point of not lower than 60 °C.

7. The binder composition for lamination according to any one of claims 1 to 6, **characterized by** having elastic modulus at 170 °C of an order of not lower than 10⁸ Pa after curing.

8. The binder composition for lamination according to any one of claims 1 to 7, **characterized by** being used for adhesion of copper foil onto glass fiber reinforced epoxy resin substrate.

9. An adhesive film, **characterized by** comprising a laminated binder layer of the binder composition for lamination according to any one of claims 1 to 8, on a surface of a substrate film made of polyethylene terephthalate.
